Europäisches Patentamt

European Patent Office

Office européen des brevets

(11) Publication number: **0 199 420 B1**

(12)
# EUROPEAN PATENT SPECIFICATION

(45) Date of publication of patent specification: **22.01.92**　(51) Int. Cl.⁵: **H02H 9/02**, H03K 17/73, H04M 3/00

(21) Application number: **86200679.8**

(22) Date of filing: **22.04.86**

(54) Electronic contact with associated power limiting means.

(30) Priority: **26.04.85 BE 2060675**

(43) Date of publication of application:
**29.10.86 Bulletin 86/44**

(45) Publication of the grant of the patent:
**22.01.92 Bulletin 92/04**

(84) Designated Contracting States:
**DE FR GB NL**

(56) References cited:
**EP-A- 0 143 473**
**US-A- 4 533 970**

(73) Proprietor: **BELL TELEPHONE MANUFACTUR-
ING COMPANY Naamloze Vennootschap
Francis Wellesplein 1
B-2018 Antwerp(BE)**

(84) Designated Contracting States:
**NL**

Proprietor: **ALCATEL N.V.
Strawinskylaan 537 (World Trade Center)
NL-1077 XX Amsterdam(NL)**

(84) Designated Contracting States:

**DE FR GB**

(72) Inventor: **Remmerie, Guido Petrus Theophiel
Oudenaardebaan 77
B-9690 Kluisbergen(BE)**
Inventor: **van den Bossche, Luc Jozef Louis
Dries 45
B-9371 Lebbeke(BE)**
Inventor: **van de Pol, Daniel Frans Jozefina
Victorialaan 54
B-2160 Zoersel(BE)**

(74) Representative: **Vermeersch, Robert et al
BELL TELEPHONE MANUFACTURING COM-
PANY Naamloze Vennootschap Patent De-
partment Francis Wellesplein 1
B-2018 Antwerpen(BE)**

Rank Xerox (UK) Business Services

## Description

The present invention relates to an electronic contact with associated power limiting means for placing said electronic contact in an open state when the power dissipated therein exceeds a predetermined value, said power limiting means including a current protection device for preventing the current flowing through said electronic contact from exceeding a predetermined current value, and a voltage protection device for limiting said current when the voltage accross said electronic contact exceeds a predetermined voltage value.

Such an electronic contact is already known in the art, e.g. from the US patent US-A-4,533,970. Therein, when the current flowing through the electronic contact reaches the predetermined current value the current protection device places the contact in the open state. As a consequence this current decreases due to which the current protection device becomes inactive and the electronic contact tends to return to the closed state. The current flowing therethrough may then again increase and the current protection device may again become activated upon the current reaching the predetermined current value, etc. Such contact "bouncing" is undesirable as, amongst others, it may damage or destroy the electronic contact.

An object of the present invention is to provide an electronic contact of the above type, but wherein contact bouncing is inhibited.

According to the invention this object is achieved due to the fact that said electronic contact has a current versus voltage characteristic which, starting from the origin, reaches said predetermined current value for a second predetermined voltage value, across said electronic contact, smaller than said first mentioned predetermined voltage value.

In this way, the operation of the current protection device dominates that of the voltage protection device whose function is to prevent bouncing of the electronic contact. Indeed, when the electronic contact is placed in the open state by the current protection device upon the current reaching the predetermined current value the voltage across it increases and, when this voltage reaches the first predetermined voltage value, the voltage protection device becomes active and prevents the contact from returning to its closed state, independently from the status of the current protection device at that moment.

It is to be noted that the PCT application PCT/EP84/00282 published on March 28, 1985 and claiming the priority of European patent application No 84201211.4 (EP 0143473.A1) discloses a similar electronic contact associated with so-called primary and secondary power protection circuits. The primary power protection circuit is comparable to the voltage protection device of the invention since it also places the electronic contact in the open state when the voltage across the electronic contact rises to a maximum value corresponding to a predetermined current value in accordance with the I/V characteristic of the electronic contact. However, this primary power protection circuit has not the same function as the voltage protection device of the present invention because it is not used to prevent the above mentioned contact bouncing but to allow to close again the electronic contact when the power dissipated therein no more exceeds the predetermined value.

It should also to be noted that when the electronic contact is in its closed state it shows a relatively small resistance and behaves like a forwardly biassed diode i.e. having a current versus voltage (I/V) characteristic such that the angle formed with the current axis is considerably smaller than the one formed with the voltage axis. This means that even for a small value of the predetermined voltage across the electronic contact the corresponding current is relatively high and that a relatively small variation of this predetermined voltage value or/and of the angle of the above characteristic produces a considerable current variation. In a worst case, the resultant current produced by such variation may be so high that the electronic contact is damaged.

An additional advantage of the present invention is that, because the current protection device operates before the voltage protection device and is controlled by the current instead of by the voltage, the point on the I/V characteristic at which the power limiting means operate is more accurately defined.

The above mentioned and other objects and features of the invention will become more apparent and the invention itself will be best understood by referring to the following description of an embodiment taken in conjunction with the accompanying drawings wherein :

Fig. 1 is a schematic view of telephone circuitry with a High Voltage Circuit HVC including electronic devices S11 to S42 including electronic contacts according to the invention;

Fig. 2 shows the electronic device S11 of Fig. 1 in more detail;

Figs. 3 and 4 show current versus voltage characteristics for portions of the device of Fig. 2;

Fig. 5 is the current versus voltage characteristic of the electronic device S11 of Fig. 2 for positive voltages and currents.

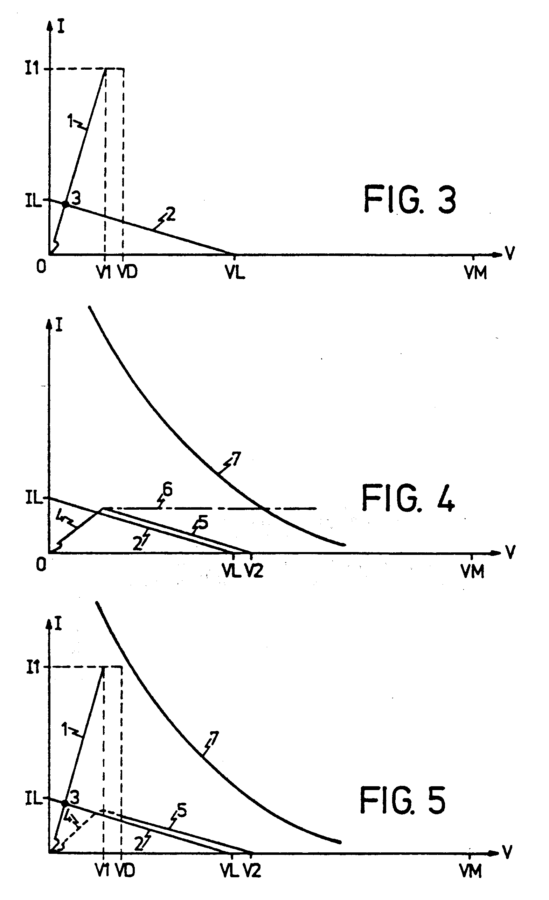

It is to be noted that the characteristics of the Figs. 3 to 5 are not drawn to scale.

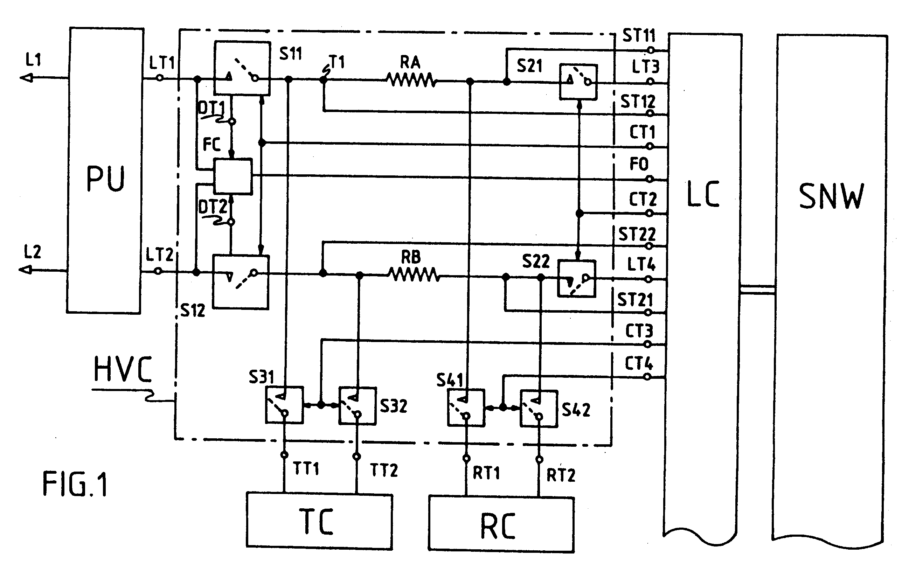

The so-called High Voltage Circuit HVC shown in Fig. 1 forms part of a telecommunication exchange and is connected on the one hand to a subscriber Line L1, L2 via a Protection Unit PU, and on the other hand to a Line Circuit LC itself coupled to a telecommunication switching network SNW. The high voltage circuit HVC is also connected to a ringing circuit RC and to a test circuit TC, and includes four pairs of electronic devices S11, S12; S21, S22; S31, S32 and S41, S42 described below, both electronic contacts of a same pair working in a same way and simultaneously. HVC further includes a fault indication circuit FC and two 50 Ohms feed resistors RA and RB, and has terminals LT1, LT2; TT1, TT2; RT1, RT2 and LT3, LT4, CT1 to CT4, ST11, ST12, ST21, ST22, FO connected to the like named terminals of the protection unit PU, the test circuit TC, the ringing circuit RC and the line circuit LC respectively. More particulary, LT1 is connected to LT3 via S11, RA and S21 in series and LT2 is connected to LT4 via S12, RB and S22 in series. The junction point T1 of S11 and RA and the junction point of S12 and RB are connected to terminals TT1 and TT2 of test circuit TC via the electronic devices S31 and S32 respectively, and the junction points of RA and S21 and of RB and S22 are connected to terminals RT1 and RT2 of ringing circuit RC via the electronic devices S41 and S42 respectively. The ends of resistors RA and RB are connected to sense terminals ST12, ST11 and ST22, ST21 of line circuit LC which is able to sense the current flowing through RA and RB and to take appropriate actions. Control terminals of the pairs of electronic devices S11, S12; S21, S22; S31, S32 and S41, S42 are repectively connected to control terminals CT1, CT2, CT3 and CT4 of line circuit LC which is able to open or close any of these pairs. Detection terminals DT1 and DT2 of the respective electronic devices S11 and S12 are connected to like named input terminals of the fault indication circuit FC whose output terminal FO is connected to the line circuit LC. The fault indication circuit FC is decribed in more detail in the European patent application mentioned above.

Ringing circuit RC is adapted to provide across the terminals RT1 and RT2 a ringing voltage constituted by an AC voltage superposed on a DC voltage. By a suitable control of the electronic devices this ringing voltage can be applied to the conductors L1 and L2 of the subscriber line via the electronic devices S41, S11 and S42, S12 respectively, the other electronic devices being in an open condition.

Test circuit TC is adapted to connect test signals to the subscriber line L1, L2 or to line circuit LC by a suitable control of the electronic devices S11, S32 and S11, S12 or S21, S22.

Each of the electronic devices S11 to S42 includes two identical undirectional switching circuits which are connected in anti-parallel across the two terminals of the electronic device and which are adapted to pass or block opposite portions of signals applied to it respectively. The electronic devices S21 to S42 are identical and their switching circuits include an electronic contact or thyristor of the TRIMOS type (MOS TRIac) such as the one described in the above mentioned European patent application. Also the electronic devices S11 and S12 are identical but each of them distinguishes from the other ones by the fact that its two switching circuits each includes individual power protection devices or circuits and that one of these power protection circuits is connected to the fault indication circuit FC.

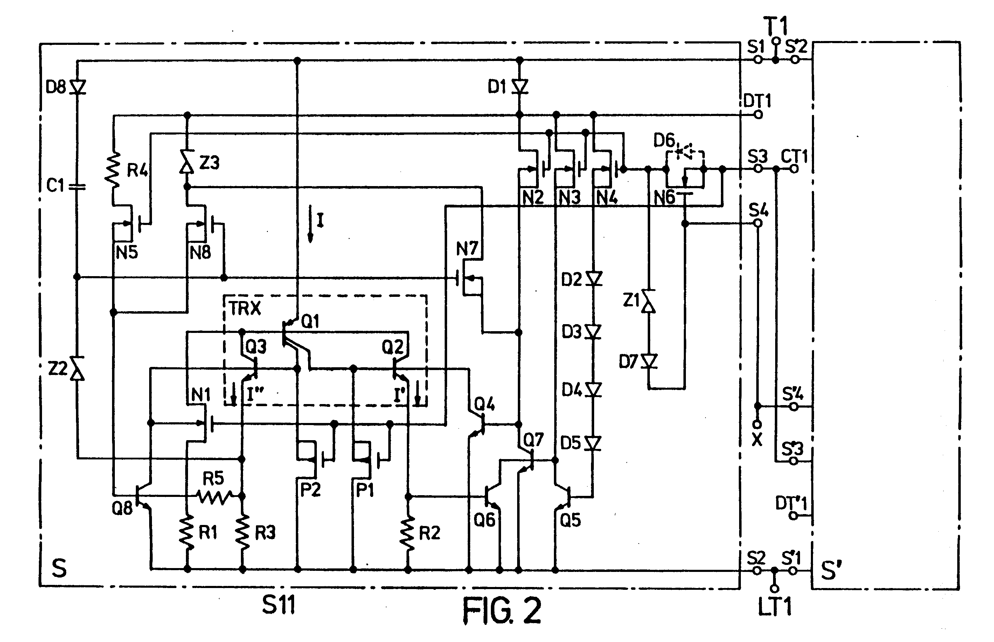

Reference is now made to Fig. 2 which shows the electronic device S11 of Fig. 1 in detail. The switching circuits S and S' of this device S11 are each constituted by a TRIMOS thyristor TRX connected between the terminals T1 and LT1 and comprising a PNP transistor Q1 having two distinct collector electrodes respectively connected to the base electrodes of two NPN transistors Q2 and Q3. The individual power protection circuits mentioned above are associated to TRX.

The switching circuit S has a terminal S1 connected, together with terminal S'2 of S', to the terminal T1, whilst terminal S2 of S and terminal S'1 of S' are both connected to the terminal LT1. The control terminal CT1 is connected to S and S' via their respective terminals S3 and S'3. The terminals S4 of S and S'4 of S' are both connected to a terminal X which is coupled to the one of the terminals T1 and LT1 which has the most negative voltage polarity. A circuit to realize such a coupling is described in the above mentioned European patent application. The switching circuits S and S' are also each provided with a detection terminal DT1, DT'1 of which only DT1 is connected to the fault indication circuit FC. Because S and S' are identical only one of them, e.g. S, is now considered.

As mentioned above, transistor Q1 of the thyristor TRX has two distinct collector electrodes connected to the base electrodes of the transistors Q2 and Q3 respectively. The collector electrodes of the transistors Q2 and Q3 are both connected to the base electrode of Q1. The base electrode of Q1 is further connected to terminal S2 via the series connection of the drain-to-source path of a DMOS transistor N1 and a resistor R1. The substrate of the DMOS transistor N1 is connected to the base electrode of the NPN transistor Q3. The base electrodes of Q2 and Q3 are also connected to the terminal S2 via the source-to-drain paths of PMOS transistors P1 and P2 respectively. The MOS transistors N1 and P1, P2 are respectively used to close and open the TRX in the way described in the above mentioned European patent application. Terminal S1 is connected to the emitter electrode of Q1 and the emitter electrodes of the transistors Q2 and Q3 are connected to terminal S2 via sense resistors R2 and R3 respectively. The base electrode of Q2 is also connected to the collector electrode of an NPN transistor Q4 whose emitter electrode is connected to terminal S2. Terminal S1 is furthermore connected to the base electrode of Q4 via the cascade connection of a diode D1 and the drain-to-source path of an NMOS transistor N2. The cathode of diode D1 is also connected to terminal S2 via the series connection of the drain-to-source path of an NMOS transistor N3 and the collector-to-emitter paths of NPN transistors Q5 and Q6 in parallel, and via the series connection of the drain-to-source path of another NMOS transistor N4, the cascade connection of diodes D2, D3, D4 and D5 and the base-to-emitter junction of the NPN transistor Q5. The base electrode of Q4 is furthermore connected to the collector electrode of an NPN transistor Q7 whose emitter electrode is connected to terminal S2 and whose base electrode is connected to both the collector electrodes of Q5 and Q6. The base electrode of Q6 is connected to the junction point of the emitter electrode of Q2 and resistor R2.

The cathode of diode D1 is also connected to the terminal S2 via the series connection of a resistor R4, the drain-to-source path of an NMOS transistor N5 and resistors R5 and R3. The junction point of the resistors R5 and R3 is connected to the emitter electrode of transistor Q3, and the junction point of the source electrode of N5 and resistor R5 is connected to the base electrode of an NPN transistor Q8 whose collector and emitter electrodes are connected to the base electrode of Q3 and to the terminal S2 respectively. The gate electrodes of the transistors N2, N3, N4 and N5 are all connected to the drain electrode of a DMOS transistor N6 having its source electrode connected to the terminal S3 and its gate electrode connected to the terminal S4. The drain electrode of the DMOS transistor N6 is further connected to the terminal S4 via the series connection of a Zener diode Z1 and a diode D7. To be noted that the DMOS transistor N6 has a parasitic diode D6 whose anode and cathode are connected to the source and the drain electrodes of N6 respectively, and that the NMOS transistors N2, N3, N4 and N5 have high gate capacitances (not shown). The gate electrodes of N1, P1 and P2 are all directly connected to the terminal S3.

The terminal S1 is also connected to the emitter electrode of transistor Q3 via the series connection of a diode D8, a capacitor C1 and a Zener diode Z2. The junction point of the capacitor C1 and the cathode of the Zener diode Z2 is connected to the gate electrodes of two NMOS transistors N7 and N8 whose drain electrodes are both connected to the anode of a Zener diode Z3 which has its cathode connected to the cathode of diode D1. The source electrodes of the transistors N7 and N8 are connected to the base electrodes of the transistor Q4 and Q8 respectively.

The electronic contact TRX is associated with two distinct power protection circuits, hereinafter called primary and secondary power protection circuits respectively. The primary power protection circuit comprises the components D1 to D5, N2 to N4, R2 and Q4 to Q7, and is adapted to open the portion Q1/Q2 of the TRX when the current flowing in the switching circuit S exceeds a predetermined value and to keep the TRX in the open state as long as the voltage across the latter has a too high value. The secondary power protection circuit comprises the components D1, N5, R3 to R5 and Q8 and is adapted to open the other portion Q1/Q3 of the TRX when the primary power protection circuit becomes active. In the following description of the operation of the power protection circuits it is assumed that the voltage at terminal S1 is positive with respect to the one at terminal S2 so that all the diodes D2 to D8 and more particularly the diode D1 are forwardly biased and that the terminal X is connected to the terminal S2. The same description is valid for S' in case the voltage at S'1 is positive with respect to the one at S'2, the terminal X being then connected to the terminal S'2.

The primary and secondary power protection circuits may be brought into and out of service by the respective NMOS transistors N2, N3, N4 and N5 which are themselves controlled by the DMOS transistor N6. To close the electronic contact TRX, a positive control voltage of about +20 Volts, applied to terminal S3 from control terminal CT1, is transmitted to the gate electrodes of N2, N3, N4 and N5 via the parasitic diode D6 of transistor N6 and is latched in the high gate capacitances of these transistors N2, N3, N4 and N5. As a result, the latter transistors N2, N3, N4 and N5 become conductive and thus bring the power protection circuits into service. The positive control voltage is also applied to the gate electrodes of the transistors P1, P2 and N1, and the latter closes the electronic contact TRX in the way explained in detail in the above mentioned European patent application. To normally open the electronic contact TRX the control voltage at S3 is decreased from its positive value of about +20 Volts to a negative value of about -20 Volts. During this voltage transition, TRX opens because both the PMOS transistors P1 and P2 become conductive when the voltage at S3 reaches about -3 Volts. However, both the primary and the secondary power protection circuits remain in service even when the parasitic diode D6 of the DMOS transistor N6 is blocked by this negative voltage. Indeed, the NMOS transistors N2, N3, N4 and N5 remain conductive due to the positive voltage being latched in their high gate capacitances, as mentioned above. When the control voltage at S3 reaches about -8 Volts, transistor N6 becomes conductive so that this negative control voltage is then applied to the gate electrodes of N2, N3, N4 and N5 which are thus blocked. As a consequence, the power protection circuits are then out of service. From the above it follows that the transistor N6 coupled to the gate capacitances of the transistors N2, N3, N4 and N5 constitute a delay circuit which brings the two power protection circuits out of service a time interval after the blocking of TRX. Thus one is sure that the device remains protected as long as TRX is closed.

The operation of the primary power protection circuit will now be analyzed. Therefore, only the portion Q1/Q2 of the TRX to which that protection circuit is associated is considered. The portion Q1/Q3 is coupled to the second power protection circuit whose operation will be analyzed later.

When a positive voltage is applied to the terminal S3, the TRX is closed by the DMOS transistor N1 and a current I' flows through the emitter of Q2 and the sense resistor R2. As long as the voltage drop across this resistor R2 does not exceed the base-to-emitter saturation voltage VBE of the transistor Q6, the latter remains blocked. On the other hand, when the voltage across the switching circuit S does not exceed a threshold value equal to six diode drops, also transistor Q5 remains blocked. These six diode voltage drops are caused by the diodes D1 to D5 and the base-to-emitter junction of Q5. It is to be noted that the voltage drops across the drain-to-source paths of the conductive MOS transistors N2 to N4 are negligible. The transistors Q5 and Q6 being blocked, transistor Q7 becomes conductive when the voltage across the switching circuit S exceeds two diode drops caused by the diode D1 and by the base-to-emitter junction of Q7. A shunt path to the terminal S2 is then formed by the collector-to-emitter path of Q7 for the base-to-emitter junction of Q4 so that the latter is blocked. In these conditions the primary power protection circuit is in service but inactive.

When the voltage drop caused by the current I' in the sense resistor R2 exceeds the base-to-emitter saturation voltage VBE of Q6, the latter becomes conductive. As a consequence, the collector-to-emitter path of Q6 forms a shunt path to terminal S2 for the base-to-emitter junction of transistor Q7. Transistor Q7 is thus blocked and, as a result, the voltage at the base electrode of Q4 increases so that Q4 then becomes conductive and derives the collector current of Q1 from the base of Q2 to terminal S2. As the base current of transistor Q2 is reduced, its collector current and consequently the base current of transistor Q1 are also reduced. As a result, the portion Q1/Q2 of the electronic contact TRX opens whilst the state of its portion Q1/Q3 remains unchanged, as will be described later. It is to be noted that Q4 is connected in parallel with P1 and that these two transistors operate in a similar way to open the electronic contact TRX.

It should also be noted that, owing to the presence of resistor R1, the effect of the protection circuits to open the TRX dominates the effect of the DMOS transistor N1 which tries to close the TRX as long as the voltage at terminal S3 remains positive.

Since the TRX is open, the current I' is reduced to zero whilst the voltage across the switching circuit S increases. As a result , the voltage drop across R2 becomes smaller than VBE of Q6 so that the latter is blocked. Transistor Q7 then again becomes conductive and blocks transistor Q4. The TRX could thus again be closed owing to the positive voltage still present at the terminal S3. To avoid the TRX to be closed again, and thus to oscillate, the primary power protection circuit is provided with a voltage protection circuit which operates as follows.

As the TRX is open, the voltage across it and therefore across the switching circuit S increases. As long as this voltage does not exceed the above mentioned threshold voltage equal to six diode drops, no current flows through the path formed by D1, N4, D2, D3, D4, D5 and the transistor Q5 of the primary power protection circuit. However, when this threshold voltage is exceeded, a current starts flowing through that path and transistor Q5 becomes conductive. As a result, transistor Q7 is blocked and transistor Q4 becomes conductive so that the TRX is open in the way described above.

From the above it follows that the transistor Q4 is controlled by both the transistors Q5 and Q6 via the inverting transistor Q7. It would be possible to control transistor Q2 directly from Q5 and Q6 instead of via Q7 and Q4, but in that case Q5 and Q6 would have to be power transistors because each of them has to be able to derive a considerable current in order to rapidly open the TRX. However, with the present circuit only transistor Q4 has to be a power transistor. The other transistors Q5, Q6 and Q7 may be smaller and this has the advantage that they can be integrated on a smaller surface than a power transistor.

The above described operation of the switching circuit S is now considered by making reference to Fig.3 which shows the current versus voltage characteristic of this circuit by considering only the portion Q1/Q2 of TRX. In this characteristic, part 1 is the normal I/V characteristic of the electronic contact TRX. The primary power protection has been so designed that this part 1 raises to a maximum current I1 corresponding to a voltage V1 and defined by the sense resistor R2, before the threshold voltage VD, defined by the diodes D1 to D5 and the base-to-emitter junction of Q5, is reached. In this protection circuit, the current protection dominates thus the voltage protection. According to requirements which are conventional for a telecommunication system, the primary power protection circuit should only be activated for a maximum current I1 ranging between 270 and 400 milli-Amperes. The threshold voltage VD is, for instance, equal to about 3.6 Volts.

Also the DC load line 2 of the switching circuit S is represented in the diagram of Fig. 3. It is defined by two points corresponding, for normal working conditions, to the maximum current IL (80 milli-Amperes) in the telecommunication line when the latter is short-circuited and to the maximum voltage VL (60 Volts) when this line is open respectively. This DC load line 2 crosses part 1 of the I/V characteristic of the switching circuit S at a stable working point 3 which is the normal working point for the telecommunication line.

When unwanted abnormal signals are applied to the telecommunication line they are added to the normal signals generated by the telecommunication exchange so that the load line 2 moves in the I/V diagram of Fig. 3. Such abnormal signals may have various origins, like lightning striking the telecommunication line or main power supply accidentally connected to that line. The working point 3 then moves along part 1 of the I/V characteristic. When these unwanted abnormal signals become very large, the load line could be displaced in such a way that the working point reaches the upper end (I1) of part 1 of the I/V characteristic. This working point then becomes unstable and immediately moves to higher voltages whilst the electronic contact TRX opens owing to the power protection circuits. However, the maximum voltage VM across the switching circuit S is limited to about 250 Volts by the protection unit PU (Fig. 1) mentioned above so that the working point is then located at point VM on the voltage axis.

When the abnormal signals disappear the DC load line shifts back into the position drawn in Fig. 3 and the working point moves back from VM (250 Volts) to VL (60 Volts) where the DC load line 2 crosses the voltage axis which corresponds to the I/V characteristic of the TRX when the latter is open (I = 0). The working point thus becomes stable at that voltage VL and since the voltage protection of the primary power protection circuit is then still active, it is impossible to close the electronic contact TRX. To allow TRX to be closed again, it should have a I/V characteristic which does not cross the DC load line 2 at a point distinct of point 3 so that no stable working point such as VL should exist between VM and this normal working point 3 . A solution is to use the secondary power protection circuit described hereinafter.

By making reference to Figs. 2 and 4, only this secondary power protection circuit associated to the portion Q1/Q3 of TRX is now considered. When the switching circuit S is closed a current flows from S1 to S2 (Fig. 2) not only via TRX but also via diode D1, resistor R4, drain-to-source path of conductive NMOS transistor N5 and resistors R5 and R3 in series. As long as the voltage between the terminals S1 and S2 is relatively so small that the voltage drop produced by the above currents across R5 and R3 in series is smaller than the base-to-emitter saturation voltage VBE of Q8, the latter transistor remains blocked. The current I flowing through TRX then varies in function of the voltage V measured across the switching circuit S according to part 4 of the I/V characteristic shown in Fig. 4.

When the voltage between the terminals S1 and S2 is so large that the voltage drop produced across R5 and R3 in series by the above mentioned currents becomes larger than the base-to-emitter saturation voltage VBE of Q8, the latter becomes conductive and thereby forms a shunt path to S2 for the base current of Q3. Thus the collector current of Q3 and hence the base current of Q1 are reduced, as a result of which the impedance of TRX increases so that the current I flowing through the latter decreases in function of V in the way represented by part 5 of the I/V characteristic of Fig. 4. This variation is function of the power dissipated in TRX because the voltage drop developped across the switching circuit S not only depends on the emitter current I'' of Q3, because R3 is connected in series with TRX, but also on V since an additional current which is function of V flows through R3 via R4 and R5. Without R4 and R5 the current in the switching circuit S would remain constant and be approximatively equal to the current IL as shown by part 6 of the I/V characteristic of Fig. 4. In that case the power dissipated in the switching circuit S could become excessive since part 6 crosses the line of maximum power dissipation 7 of the circuit S. Furthermore, for the reasons mentioned above, part 5 of the I/V characteristic should not cross the DC load line 2. On the other hand, because the minimum power dissipated in the switching circuit occurs at the working point of this circuit, i.e. at the crosspoint of part 4 of the I/V characteristic and the DC load line 2, part 5 of the I/V characteristic should be chosen as close as possible to the DC load line 2 in order to obtain a minimum of power dissipation in the switching circuit S. Therefore, the slope of part 5 of the I/V characteristic is chosen similar to the slope of the DC load line 2 and the maximum current is chosen slightly above this load line 2 whilst the maximum voltage V2 is chosen slightly above VL. In this example the maximum current is equal to about 100 milli-Amperes and V2 is equal to 100 Volts approximatively. However, according to the requirements given above, if the maximum current is chosen higher than the required minimum of 270 milli-Amperes, part 5 of the I/V characteristic should be shifted upwardly and a portion of it may then become located above the line of maximum power dissipation 7. In that case, when the secondary power protection circuit becomes active, the power dissipated in S may be so large that the latter is destroyed.

The drawbacks of the two power protection circuits taken separately may be eliminated by combining these two circuits, this combination providing the overall I/V characteristic of the switching circuit S represented in Fig. 5. This characteristic comprises part 1 of the I/V characteristic related to the primary power protection circuit and part 5 of the I/V characteristic related to the secondary power protection circuit. From this Fig. 5 it appears clearly that the I/V characteristic crosses the above mentioned DC load line 2 at the stable and unique working point 3, and that the power dissipated in the switching circuit S is reduced to its minimum since part 5 is very close to the DC load line 2.

It is to be noted that due to the values of the components of the switching circuit S, the current I (Fig. 2) flowing through TRX is much larger than any other currents flowing through the protection circuits. Hence, the current I may be considered to be the current flowing through the switching circuit S so that the I/V characteristics of the Figs. 3 to 5 are valid for the thyristor TRX as well as for the switching circuit S.

The present device also includes auxiliary protection circuits constituted by the diodes D7 and D8, the Zener diodes Z1 to Z3, the capacitor C1 and the MOS transistors N7 and N8. These circuits are described hereinafter by making reference to Fig. 2.

When a voltage of about -20 Volts is present at terminal S3, the electronic contact TRX is open and the transistors P1 and P2 are conductive whilst N1 is blocked. If an unwanted spike signal with a high positive value appears at terminal S1, a proportional spike signal can also appear at the terminal S3 due to parasitic capacitive couplings between the terminals. The voltage at terminal S3 can thus become positive so that the transistors P1 and P2 are then blocked while the DMOS transistor N1 becomes conductive. As a result, the TRX will be closed. To avoid this unwanted effect the above mentioned spike signal is also transmitted via diode D8 and capacitor C1 to the gate electrodes of the transistors N7 and N8. These transistors N7 and N8 become then conductive and apply a positive voltage to the base electrodes of the transistor Q4 and Q8 respectively. As a consequence, the two power protection circuits are activated so that the TRX cannot be closed although a positive voltage is present at terminal S3.

The Zener diode Z2 protects the transistors N7 and N8 against too high values of the unwanted spike signals.

The Zener diode Z3 defines a threshold preventing activation of the protection circuits in case a spike signal of lower value than this threshold is applied to the circuit, e.g. a spike signal caused by a subscriber off-hook action.

The circuit comprising the Zener diode Z1 and the diode D7 protects the transistors N2 to N6 against excessively high voltages which may appear at the terminals S3 and S4.

While the principles of the invention have been described above in connection with specific apparatus, it is to be clearly understood that this description is made only by way of example and not as a limitation on the scope of the invention as defined by the claims.

## Claims

1. Electronic contact (TRX) with associated power limiting means for placing said electronic contact (TRX) in an open state when the power dissipated therein exceeds a predetermined value, said power limiting means including a current protection device (R2, Q4, Q6, Q7) for preventing the current flowing through said electronic contact (TRX) from exceeding a predetermined current value (I1), and a voltage protection device (D1 to D5, Q4, Q5, Q7) for limiting said current when the voltage accross said electronic contact exceeds a predetermined voltage value (VD), characterized in that said electronic contact (TRX) has a current (I) versus voltage (V) characteristic which, starting from the origin, reaches said predetermined current value (I1) for a second predetermined voltage value (V1), across said electronic contact (TRX), smaller than said first mentioned predetermined voltage value (VD).

2. Electronic contact according to claim 1, characterized in that said current (R2, Q4, Q6, Q7) and voltage (D1 to D5, Q4, Q5, Q7) protection devices are coupled in series and in parallel with said electronic contact (TRX) respectively, and have a common output terminal coupled to a control terminal of said electronic contact, said control terminal being used for placing said electronic contact in said open state.

3. Electronic contact according to claim 2, characterized in that said common output terminal is constituted by the common collector electrodes of a first (Q6) and a second (Q5) transistors forming part of said current (R2, Q4, Q6, Q7) and voltage (D1 to D5, Q4, Q5, Q7) protection devices respectively, the base-to-emitter junction of said first transistor (Q6) being shunted by a current sensing impedance (R2) and the base-to-emitter junction of said second transistor (Q5) being coupled in series with a voltage sensing impedance (D1 to D5).

4. Electronic contact according to claim 2, characterized in that said common output terminal is coupled to said control terminal via a bistate device (Q4, Q7).

5. Electronic contact according to claims 3 and 4, characterized in that said bistate device (Q4, Q7) includes a third transistor (Q7) whose base-to-emitter junction is shunted by the collector-to-emitter paths of both said first (Q6) and second (Q5) transistors and whose collector-to-emitter path shunts the base-to-emitter junction of a fourth transistor (Q4), also forming part of said bistate device and whose collector electrode is connected to said control terminal.

6. Electronic contact according to claim 2, characterized in that it includes an auxiliary protection circuit (D8, C1, N7, N8, Z2, Z3) preventing the operation of said electronic contact (TRX) by spike signals applied to its terminals, said auxiliary protection circuit including a spikes detection circuit (N7, N8) with a control terminal and a first output terminal coupled to one (S1) of said terminals of said electronic contact via capacitance means (C1) and voltage threshold means (Z3) respectively, and with a second output terminal coupled to said control terminal of said electronic contact (TRX).

7. Electronic contact according to claim 6, characterized in that said second output terminal of said spikes detection circuit (N7, N8) is connected to the base electrode of said fourth transistor (Q4).

8. Electronic contact according to claim 6, characterized in that said spikes detection circuit (N7, N8) includes at least one MOS transistor (N7) whose gate, drain and source electrodes from said control terminal, said first output terminal and said second output terminal respectively.

9. Electronic contact according to claim 6, characterized in that the control terminal of said spikes detection circuit (N7, N8) is coupled to another (S2) of said terminals of said electronic contact (TRX) via second voltage threshold means (Z2).

**Revendications**

1. Contact électronique (TRX) avec des moyens associés de protection contre les surcharges pour mettre ledit contact électronique (TRX) à l'état ouvert quand la puissance dissipée dans le contact dépasse une valeur prédéterminée, lesdits moyens de protection contre les surcharges comprenant un dispositif de protection contre les surintensités (R2, Q4, Q6, Q7) pour empêcher le courant traversant ledit contact électronique (TRX) de dépasser une valeur prédéterminée (I1) et un dispositif de protection contre les surtensions (D1 à D5, Q4, Q5, Q7) pour limiter ledit courant quand la tension aux bornes dudit contact électronique dépasse une valeur prédéterminée (VD), caractérisé par le fait que ledit contact électronique (TRX) a une courbe caractéristique de courant (I) en fonction de la tension (V) qui, partant de l'origine, atteint une valeur de courant prédéterminée (I1) pour une seconde valeur de tension prédéterminée (V1) aux bornes dudit contact électronique (TRX), inférieure à ladite valeur de tension prédéterminée mentionnée en premier lieu (VD).

2. Contact électronique selon la revendication 1, caractérisé par le fait que lesdits dispositifs de protection contre les surintensités (R2, Q4, Q6, Q7) et contre les surtensions (D1 à D5, Q4, Q5, Q7) sont respectivement couplés en série et en parallèle avec ledit contact électronique (TRX) et ont une borne de sortie commune couplée à une borne de commande dudit contact électronique, ladite borne de commande étant utilisée pour mettre ledit contact électronique dans ledit état ouvert.

3. Contact électronique selon la revendication 2, caractérisé par le fait que ladite borne de sortie commune et constituée par les électrodes collectrices communes d'un premier (Q6) et d'un second (Q5) transistors faisant partie, respectivement, desdits dispositifs de protection contre les surintensités (R2, Q4, Q6, Q7) et contre les surtensions (D1 à D5, Q4, Q5, Q7), la jonction base-émetteur dudit premier transistor (Q6) étant shuntée par une impédance détectrice de courant (R2) et la jonction base-émetteur dudit second transistor (Q5) étant couplée en série avec une impédance détectrice de tension (D1 à D5).

4. Contact électronique selon la revendication 2, caractérisé par le fait que ladite borne de sortie commune est couplée à ladite borne de commande par l'intermédiaire d'un dispositif à deux états (Q4, Q7).

5. Contact électronique selon les revendications 3 et 4, caractérisé par le fait que ledit dispositif à deux états (Q4, Q7) contient un troisième transistor (Q7) dont la jonction base-émetteur est shuntée par les chemins collecteur-émetteur des deux dits premier (Q6) et second (Q5) transistors et dont le chemin collecteur-émetteur shunte la jonction base-émetteur d'un quatrième transistor (Q4) faisant également partie dudit dispositif à deux états et dont l'électrode collectrice est connectée à ladite borne de commande.

6. Contact électronique selon la revendication 2, caractérisé par le fait qu'il contient un circuit de protection auxiliaire (D8, C1, N7, N8, Z2, Z3) empêchant le fonctionnement dudit contact électronique (TRX) sous l'effet de signaux transitoires appliqués à ses bornes, ledit circuit de protection auxiliaire contenant un circuit de détection des transitoires (N7, N8) avec une borne de commande et une première borne de sortie couplées à l'une (S1) desdites bornes dudit contact électronique respectivement par l'intermédiaire d'un dispositif capacitif (C1) et d'un dispositif à seuil de tension (Z3), et avec une seconde borne de sortie couplée à ladite borne de commande dudit contact électronique (TRX).

7. Contact électronique selon la revendication 6, caractérisé par le fait que ladite seconde borne de sortie dudit circuit de détection des transitoires (N7, N8) est connectée à l'électrode de base dudit quatrième transistor (Q4).

8. Contact électronique selon la revendication 6, caractérisé par le fait que ledit circuit de détection des transitoires (N7, N8) contient au moins un transistor MOS (N7) dont les électrodes de grille, de drain et de source constituent respectivement ladite borne de commande, ladite première borne de sortie et ladite seconde borne de sortie.

9. Contact électronique selon la revendication 6, caractérisé par le fait que la borne de commande dudit circuit de détection des transitoires (N7, N8) est couplée à une autre (S2) desdites bornes dudit contact électronique (TRX) par l'intermédiaire d'un second dispositif à seuil de tension (Z2).

**Patentansprüche**

1. Elektronischer Kontakt (TRX) mit zugeordneten Leistungsbegrenzungsmitteln, um den elektronischen Kontakt (TRX) zu öffnen, wenn die darin verbrauchte Leistung einen vorgegebenen Wert übersteigt, wobei die Leistungsbegrenzungsmittel eine Strom-Schutzschaltung (R2, Q4, Q6, Q7) enthält, die den durch den elektronischen Kontakt (TRX) fließenden Strom daran hindert, einen vorgegebenen Stromwert (I1) zu übersteigen, und eine Spannungs-Schutzschaltung (D1 bis D5, Q4, Q5, Q7), um den Strom zu begrenzen, wenn die Spannung an dem elektronischen Kontakt einen vorgegebenen Spannungswert (VD) übersteigt, **dadurch gekennzeichnet,** daß der elektronische Kontakt (TRX) eine Strom(I)-Spannungs-(V)-Kennlinie aufweist, die, ausgehend vom Ursprung, den vorgegebenen Stromwert (I1) bei einem zweiten vorgegebenen Spannungswert (V1) an dem elektronischen Kontakt (TRX) erreicht, der kleiner ist als der erstgenannte vorgegebene Spannungswert (VD).

2. Elektronischer Kontakt nach Anspruch 1, dadurch gekennzeichnet, daß die Strom-Schutzschaltung (R2, Q4, Q6, Q7) in Serie mit und die Spannungs-Schutzschaltung (D1 bis D5, Q4, Q5, Q7) parallel zu dem elektronischen Kontakt (TRX) angeordnet sind und einen gemeinsamen Ausgangsanschluß aufweisen, der mit einem Steueranschluß des elektronischen Kontakts verbunden ist und daß der Steueranschluß dazu verwendet wird, den elektronischen Kontakt zu öffnen.

3. Elektronischer Kontakt nach Anspruch 2, dadurch gekennzeichnet, daß der gemeinsame Ausgangsanschluß durch die gemeinsamen Kollektoranschlüsse eines ersten (Q6) und eines zweiten (Q5) Transistors gebildet wird, die Teil der Strom-Schutzschaltung (R2, Q4, Q6, Q7) bzw. der Spannungs-Schutzschaltung (D1 bis D5, Q4, Q5, Q7) sind, daß der Basis-Emitter-Strecke des ersten Transistors (Q6) ein Widerstand (R2) als Stromfühler parallel geschaltet ist und daß in Reihe mit der Basis-Emitter-Strecke des zweiten Transistors (Q5) ein Spannungsfühler (D1 bis D5) geschaltet ist.

4. Elektronischer Kontakt nach Anspruch 2, dadurch gekennzeichnet, daß der gemeinsame Ausgangsanschluß durch ein bistabiles Element (Q4, Q7) mit dem Steueranschluß verbunden ist.

5. Elektronischer Kontakt nach den Ansprüchen 3 und 4, dadurch gekennzeichnet, daß das bistabile Element (Q4, Q7) einen dritten Transistor (Q7) enthält, dessen Basis-Emitter-Strecke parallel geschaltet ist mit den Kollektor-Emitter-Strecken sowohl des ersten (Q6) als auch des zweiten (Q5) Transistors und dessen Kollektor-Emitter-Strecke mit der Basis-Emitter-Strecke eines vierten Transistors (Q4) parallel geschaltet ist, der ebenfalls Teil des bistabilen Elements ist und dessen Kollektor mit dem Steueranschluß verbunden ist.

6. Elektronischer Kontakt nach Anspruch 2, dadurch gekennzeichnet, daß er eine Hilfs-Schutzschaltung (D8, C1, N7, N8, Z2, Z3) aufweist, die die Funktion des elektronischen Kontakts auch bei an seinen Anschlüssen anliegenden Spikesignalen gewährleistet, daß die Hilfs-Schutzschaltung eine Schaltung (N7, N8) zur Spikeserkennung enthält, die einen Steueranschluß und einen ersten Ausgangsanschluß aufweist, die mit einem (S1) der Anschlüsse des elektronischen Kontakts über kapazitive (C1) bzw. eine Spannungsschwelle bildenden (Z3) Mittel verbunden sind und die einen zweiten Ausgangsanschluß aufweist, der mit dem Steueranschluß des elektronischen Kontakts verbunden ist.

7. Elektronischer Kontakt nach Anspruch 6, dadurch gekennzeichnet, daß der zweite Ausgangsanschluß der Schaltung (N7, N8) zur Spikeserkennung mit der Basis des vierten Transistors (Q4) verbunden ist.

8. Elektronischer Kontakt nach Anspruch 6, dadurch gekennzeichnet, daß die Schaltung (N7, N8) zur Spikeserkennung mindestens einen MOS-Transistor enthält, dessen Steuer-, Drain- und Sourceanschlüsse den Steueranschluß bzw. den ersten Ausgangsanschluß bzw. den zweiten Ausgangsanschluß bilden.

9. Elektronischer Kontakt nach Anspruch 6, dadurch gekennzeichnet, daß der Steueranschluß der Schaltung (N7, N8) zur Spikeserkennung über zweite, eine Spannungsschwelle bildende, Mittel (Z2) mit einem weiteren (S2) der Anschlüsse des elektronischen Kontakts (TRX) verbunden ist.

FIG.1

EP 0 199 420 B1

FIG. 2

FIG. 3

FIG. 4

FIG. 5